# EUROPEAN PATENT APPLICATION

(11) **EP 2 940 736 A1**
(43) Date of publication of application: **04.11.2015**
(21) Application number: 13866575.7
(22) Date of filing: 06.12.2013
(51) Int. Cl.: H01L 31/06

(54) **COMPOUND THIN-FILM SOLAR CELL AND PRODUCTION METHOD FOR SAME**

(30) Priority: 27.12.2012 JP 2012286186
(71) Applicant: Solar Frontier K.K., Minato-ku Tokyo 135-8074 (JP)
(72) Inventor: ASANO, Akihiko, Tokyo 135-8074 (JP)
(74) Representative: Beder, Jens
(86) International application number: PCT/JP2013/082883
(87) International publication number: WO 2014/103669

(57) **Abstract**

The method of manufacturing a compound thin-film photovoltaic cell, includes preparing a metal substrate, whose main constituent is iron, containing aluminium (Al) and chromium (Cr), and forming an alumina layer at least on an element forming surface of the metal substrate by thermal oxidation; forming an insulating layer on the alumina layer; depositing a first electrode layer on the insulating layer; depositing a compound light absorption layer on the first electrode layer; and depositing a second electrode layer on the compound light absorption layer.

## Description

### BACKGROUND OF THE INVENTION

### 1. Field of the Invention

The present invention relates to a compound thin-film photovoltaic cell and a method of manufacturing thereof.

### 2. Description of the Related Art

Recently, photovoltaic power generation, for which fuel is unnecessary, that does not eject greenhouse gas is getting a lot of attention. For example, a compound thin-film photovoltaic cell is known in which an inorganic insulating layer and a compound light absorption layer such as a CIS-based thin-film or the like are stacked on a metal substrate such as a stainless substrate or the like.

In such a compound thin-film photovoltaic cell, a thin insulating layer (thin-film insulating layer) composed of oxide (SiOx or the like), nitride (Si₃N₄) or the like is used as the inorganic insulating layer, for example. Further, a stainless substrate in which aluminium is added is used as a metal substrate and a thin insulating layer or the like composed of alumina obtained by performing thermal oxidation on the stainless substrate and formed at its surface is used (see Patent Document 1, for example).

### [Patent Document]

[Patent Document 1] Japanese Laid-open Patent Publication No. S63-155681

However, when considering that it is normal for the compound thin-film photovoltaic cell to integrate a plurality of cells in series to actualize a high voltage output, that defects such as oil pits, scratches or the like, which cause leaking, remain at a surface of the metal substrate, or the like, it is difficult to directly form an electrode layer or the like on the above described thin insulating layer because such a thin insulating layer cannot ensure withstand voltage.

Thus, when the metal substrate is used, it is preferable to deposit a thick glass insulating layer using glass frit or the like on the metal substrate. In particular, a large advantage can be obtained by removing the influence of the oil pits or the scratches due to the thickness of the layer.

However, when the glass insulating layer is used, delamination at an interface between the upper surface of the metal substrate, which is a lower layer, and the glass insulating layer deposited on the metal substrate becomes a problem. The delamination causes deterioration of device characteristic of the compound thin-film photovoltaic cell. The delamination occurs due to the surface condition of the metal substrate, and the stress between the metal substrate and the glass insulating layer. Further, there is a possibility that the delamination occurs not only when manufacturing the compound thin-film photovoltaic cell, but also when the photovoltaic cell is being operated thereafter. Further, the degree of occurrence of the delamination 1 is high for the metal substrate whose surface roughness is small.

### SUMMARY OF THE INVENTION

The present invention is made in light of the above problems, and provides a compound thin-film photovoltaic cell and a method of manufacturing thereof capable of suppressing delamination between a metal substrate and an insulating layer.

According to an embodiment, there is provided a method of manufacturing a compound thin-film photovoltaic cell, including: preparing a metal substrate, whose main constituent is iron, containing aluminium (Al) and chromium (Cr), and forming an alumina layer at least on an element forming surface of the metal substrate by thermal oxidation; forming an insulating layer on the alumina layer; depositing a first electrode layer on the insulating layer; depositing a compound light absorption layer on the first electrode layer; and depositing a second electrode layer on the compound light absorption layer.

According to an embodiment, there is provided a compound thin-film photovoltaic cell, including: a metal substrate, whose main constituent is iron, containing aluminium (Al) and chromium (Cr); an alumina layer formed at least on an element forming surface of the metal substrate by thermal oxidation; an insulating layer formed on the alumina layer; a first electrode layer deposited on the insulating layer; a compound light absorption layer deposited on the first electrode layer; and a second electrode layer deposited on the compound light absorption layer.

According to the disclosed technique, a compound thin-film photovoltaic cell and a method of manufacturing thereof capable of suppressing delamination between a metal substrate and an insulating layer can be provided.

### BRIEF DESCRIPTION OF THE DRAWINGS

Fig. 1 is a cross-sectional view illustrating an example of a CIS-based compound thin-film photovoltaic cell of an embodiment;
Fig. 2 is a view (No. 1) illustrating an example of manufacturing steps of the CIS-based compound thin-film photovoltaic cell of the embodiment;
Fig. 3 is a view (No. 2) illustrating an example of manufacturing steps of the CIS-based compound thin-film photovoltaic cell of the embodiment;
Fig. 4 is a view (No. 3) illustrating an example of manufacturing steps of the CIS-based compound thin-film photovoltaic cell of the embodiment;
Fig. 5 is a view for explaining a photographing direction of samples manufactured in Example 1;
Fig. 6 is a picture (No. 1) of a sample manufactured in Example 1;
Fig. 7 is a picture (No. 2) of a sample manufactured in Example 1;
Fig. 8 is a picture (No. 3) of a sample manufactured in Example 1;
Fig. 9 is a picture (No. 4) of a sample manufactured in Example 1; and
Fig. 10 is a picture of a sample manufactured as a comparative example.

### DETAILED DESCRIPTION OF THE PREFERRED EMBODIMENTS

Next, embodiments of the present invention will be described below with reference to drawings. It is to be noted that, in the explanation of the drawings, the same components are given the same reference numerals, and explanations are not repeated.

Here, although a CIS-based compound thin-film photovoltaic cell is exemplified in the following embodiment or the like, the present invention is applicable to a compound thin-film photovoltaic cell other than the CIS-based one. As an example of a compound thin-film photovoltaic cell to which the present invention is applicable, other than the CIS-based one, a CZTS-based compound thin-film photovoltaic cell may be used in which a light absorption layer is composed of a compound including copper (Cu), zinc (Zn), tin (Sn) and a chalcogen element (selenium (Se) or sulfur (S)). Further, as another example of a compound thin-film photovoltaic cell to which the present invention is applicable, other than the CIS-based one, a CdTe-based compound thin-film photovoltaic cell or the like may be used in which a light absorption layer is composed of a compound including cadmium (Cd) and tellurium (Te) .

### (Structure of CIS-based compound thin-film photovoltaic cell of embodiment)

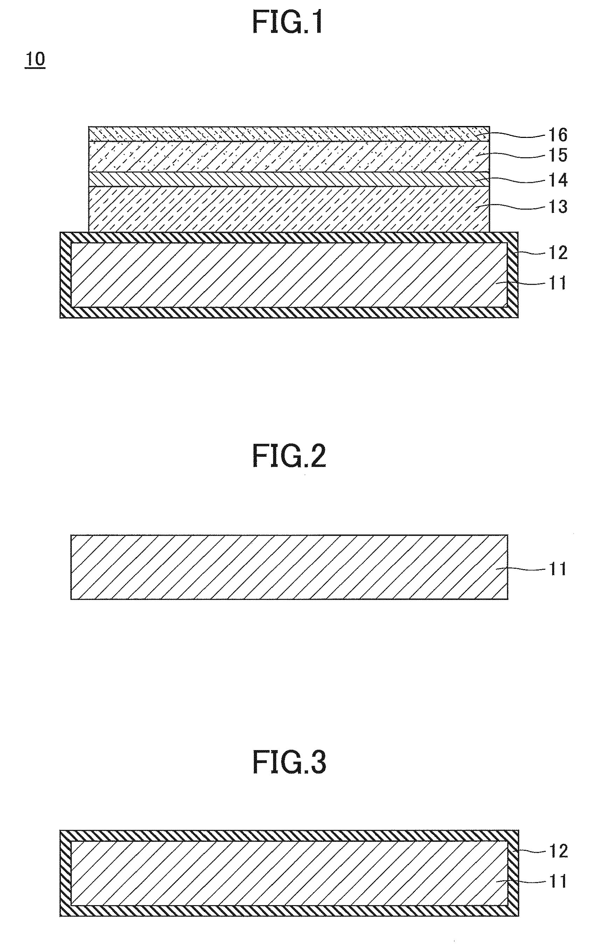

Fig. 1 is a cross-sectional view illustrating an example of the CIS-based compound thin-film photovoltaic cell of the embodiment. With reference to Fig. 1, a compound thin-film photovoltaic cell 10 includes a metal substrate 11 including an alumina layer 12 at its surface, an insulating layer 13, a first electrode layer 14, a compound light absorption layer 15 and a second electrode layer 16, in which the insulating layer 13, the first electrode layer 14, the compound light absorption layer 15 and the second electrode layer 16 are stacked on the alumina layer 12 of the metal substrate 11 in this order. Hereinafter, each component that composes the compound thin-film photovoltaic cell 10 is explained.

Here, in this application, in the substrate and layers that compose the compound thin-film photovoltaic cell 10, a surface at a light receiving side may be referred to as an "upper surface", a surface opposite to this may be referred to as a "lower surface", and a surface connecting the upper surface and the lower surface may be referred to as an "end surface". Further, the entirety of the upper surface, the lower surface and the end surfaces may be referred to as an "entire surface". Further, the upper surface of the metal substrate 11 may be particularly referred to as an "element forming surface", and the lower surface of the metal substrate 11 may be particularly referred to as a "back surface".

The metal substrate 11 is a portion that becomes a base body on which the insulating layer 13, the first electrode layer 14, the compound light absorption layer 15 and the second electrode layer 16 are formed. The metal substrate 11 is a substrate whose main constituent is iron and containing aluminium (Al) and chromium (Cr). The entire surface of the metal substrate 11 is covered by the alumina layer 12 that is formed by thermal oxidation. The thickness of the metal substrate 11 may be about 0.2 mm to 0.6 mm, for example.

It is preferable that the content of aluminium (Al) in the metal substrate 11 is greater than or equal to 0.5 weight % and less than or equal to 6.0 weight %. When the content of aluminium (Al) in the metal substrate 11 is less than 0.5 weight %, it is not preferable because the alumina layer 12 is not sufficiently formed. Further, when the content of aluminium (Al) of the metal substrate 11 exceeds 6.0 weight %, it is not preferable because the coefficient of thermal expansion of the metal substrate 11 becomes large.

As an example of the metal substrate 11, a stainless substrate containing aluminium (Al) may be used. It is particularly preferable to use a ferrite-based stainless substrate containing aluminium (Al) as the metal substrate 11. This is because the delamination of the compound light absorption layer at the heat treatment or after the heat treatment can be prevented as the coefficient of thermal expansion of the ferrite-based stainless substrate is close to that of the CIS-based compound light absorption layer.

Here, the stainless substrate is a substrate made of stainless steel. The stainless steel means chromium (Cr) or alloy steel containing chromium (Cr) and nickel (Ni), in which the content of chromium (Cr) is greater than or equal to 10.5%.

Here, the metal substrate 11 is not limited to the stainless substrate containing aluminium (Al), and a substrate whose main constituent is iron and containing aluminium (Al) and less than 10.5% of chromium (Cr) may be used, for example. In this case, the substrate may further include nickel (Ni).

In other words, the substrate whose main constituent is iron and containing aluminium (Al) and chromium (Cr) may include various stainless substrates including a ferrite-based stainless substrate and a substrate containing a kind of metal same as the stainless substrate in which the content of chromium (Cr) is less than 10.5%.

Here, when the content of the chromium (Cr) is too small, there is a possibility that the coefficient of thermal expansion of the metal substrate 11 becomes large or the surface roughness becomes large and it is difficult to use the substrate as a substrate of a photovoltaic cell. Thus, it is preferable that chromium (Cr) is included at least about 8%.

Further, in order to form a further dense alumina layer 12, the metal substrate 11 may include silicon (Si).

The alumina layer 12 covers the entire surface of the metal substrate 11. The alumina layer 12 is a layer formed such that aluminium (Al) contained in the metal substrate 11 is diffused at the entire surface of the metal substrate 11 under a predetermined condition. In a point of view of improving the adhesion with the insulating layer 13, it is preferable that the thickness of the alumina layer 12 is greater than or equal to 30 nm. Here, as the adhesion with the insulating layer 13 is retained even when the alumina layer 12 is thick, the thickness of the alumina layer 12 may be about 1 µm for a case that withstand voltage is to be improved between the metal substrate 11 and the first electrode layer 14 by a two-layered structure in which the alumina layer 12 and the insulating layer 13 are stacked.

Here, it is sufficient that the alumina layer 12 is formed at least on the upper surface (element forming surface) of the metal substrate 11. Because the adhesion of the alumina layer 12 formed on the upper surface of the metal substrate 11 and the insulating layer 13 formed right above the alumina layer 12 can be improved.

The insulating layer 13 is formed on the alumina layer 12 that is formed on the upper surface of the metal substrate 11. As the material of the insulating layer 13, it is preferable to use a glass. As an example of the glass, a glass or a low-melting glass may be used whose component is at least one selected from silica (SiO₂), CaO, B₂O₃, SrO, BaO, Al₂O₃, ZnO, ZrO₂ and MgO. The reason why the glass is preferably used as the material of the insulating layer 13 is as follows. If organic resin is used as the material of the insulating layer 13, for example, there is a possibility that the insulating layer 13 is damaged by heat treatment when depositing the compound light absorption layer 15. However, by constituting the insulating layer 13 by the glass layer that has high heat resistance, such a problem can be avoided.

Here, the insulating layer 13 may be constituted by a plurality of layers combining the above described materials, and in such a case, the insulating layer 13 may include a layer that has an alkali barrier function. The alkali barrier function is a function to prevent an excessive amount of alkali metal components such as sodium (Na), potassium (K) or the like from being diffused into the compound light absorption layer 15. It is preferable that the thickness of the layer that has the alkali barrier function is about 5 to 100 nm, for example.

It is preferable that the thickness of the insulating layer 13 is greater than or equal to 10 µm and less than or equal to 50 µm. Further, it is preferable that the coefficient of linear expansion of the insulating layer 13 is about 9.0 × 10⁻⁶ to 13.0 × 10⁻⁶/K. Here, according to the studies by the present inventors, it is revealed that the conversion efficiency of the compound thin-film photovoltaic cell 10 is lowered when the thickness of the insulating layer 13 is less than 10 µm. It is considered that this is because the surface roughness of the upper surface of the metal substrate 11 influences the surface smoothness of each layer formed on the insulating layer 13. Further, it is not preferable to form the thickness of the insulating layer 13 to be greater than 50 µm because the mechanical strength of the insulating layer 13 is lowered or the insulating layer 13 is easily delaminated or peeled from the metal substrate 11.

The first electrode layer 14 is formed on the insulating layer 13. As the material of the first electrode layer 14, molybdenum (Mo) may be used, for example. As the material of the first electrode layer 14, another metal that has high corrosion resistance against hydrogen selenide (H₂Se) or hydrogen sulfide (H₂S), for example, such as titanium (Ti), tungsten (W) or the like may be used. It is preferable that the thickness of the first electrode layer 14 is about a few dozen nm to a few µm, and may be, for example, 0.5 µm.

The compound light absorption layer 15 is a layer composed of a p-type semiconductor and is formed on the first electrode layer 14. The compound light absorption layer 15 is a portion that photoelectrically converts irradiated sunlight or the like. The photo current generated by the photoelectric conversion of the compound light absorption layer 15 can be extracted as current to outside from an electrode ribbon (copper film ribbon), not illustrated in the drawings, that is attached to either or both of the first electrode layer 14 and the second electrode layer 16 by solder or the like. It is preferable that the thickness of the compound light absorption layer 15 is about a few hundred nm to a few dozen µm, and may be 1.5 µm, for example.

The compound light absorption layer 15 is a semiconductor thin-film and may be formed by a CIS-based compound thin-film composed of IB-IIIB-VIB group elements. The material of the CIS-based compound thin-film may be at least one kind of compound semiconductor including at least one kind of IB group element selected from a group consisting of Cu and Ag, at least one kind of IIIB group element selected from a group consisting of Al, Ga and In, and at least one kind of VIB group element selected from a group consisting of S and Se.

As a specific example of the compound, copper indium 2 selenide (CuInSe₂), copper indium 2 sulfide (CuInS₂), copper indium 2 sulfide-selenide (CuIn(SSe)₂), copper gallium 2 selenide (CuGaSe₂), copper gallium 2 sulfide (CuGaS₂), copper indium gallium 2 selenide (Cu(InGa)Se₂), copper indium gallium 2 sulfide (Cu(InGa)S₂), copper indium gallium 2 sulfide-selenide (Cu(InGa)(SSe)₂) or the like may be used.

Here, as the compound light absorption layer 15, a CZTS-based compound composed of copper (Cu), zinc (Zn), tin (Sn) and a chalcogen element may be used, for example. As an specific example of the compound, 2 copper zinc tin 4 selenide (Cu₂ZnSnSe₄), 2 copper zinc tin 4 sulfide (Cu₂ZnSnS₄), 2 copper zinc tin 4 sulfide-selenide (Cu₂ZnSn(SSe)₄) or the like may be used.

A buffer layer (not illustrated in the drawings) may be formed on the compound light absorption layer 15. The buffer layer is a high resistance layer that has a function to prevent leakage of current from the compound light absorption layer 15. As the material of the buffer layer, a zinc compound (Zn(S, O, OH)) or the like may be used, for example. As the material of the buffer layer, zinc oxide (ZnO), zinc sulfide (ZnS), indium oxide (In₂O₃), indium sulfide (InS), an indium compound (In (S, O, OH)), cadmium sulfide (CdS) or the like may be used. The thickness of the buffer layer may be about a few nm to a few dozen nm, for example.

Here, an alkali barrier layer may be formed between the insulating layer 13 and the first electrode layer 14. The alkali barrier layer is a layer provided for preventing an excessive amount of alkali metal components such as sodium (Na), potassium (K) or the like from being diffused into the compound light absorption layer 15. As the material of the alkali barrier layer, silica (SiO₂) or the like may be used, for example. The thickness of the alkali barrier layer may be about 5 to 100 nm, for example.

The second electrode layer 16 is a transparent layer made of an n-type semiconductor, and is formed on the compound light absorption layer 15. The second electrode layer 16 forms a PN junction between the compound light absorption layer 15, which is made of a p-type semiconductor, and further functions as a low resistance conductor. As the second electrode layer 16, a transparent conductive film such as a zinc oxide based thin-film (ZnO), an ITO thin-film, a tin oxide (SnO₂) or the like may be used, for example. When the zinc oxide based thin-film (ZnO) is used, it is preferable to add boron (B), aluminium (Al), gallium (Ga) or the like as a dopant so that the film can be made low resistance. The thickness of the second electrode layer 16 may be about 0.5 µm to 2.5 µm, for example.

Here, the compound thin-film photovoltaic cell 10 may be an integrated structure in which a plurality of cells are connected in series.

### (Method of manufacturing CIS-based compound thin-film photovoltaic cell of embodiment)

Next, a method of manufacturing the CIS-based compound thin-film photovoltaic cell of the embodiment is explained. Fig. 2 to Fig. 4 are views illustrating an example of manufacturing steps of the CIS-based compound thin-film photovoltaic cell of the embodiment.

First, in a step illustrated in Fig. 2, the metal substrate 11 is prepared. The metal substrate 11 is a substrate whose main constituent is iron and containing aluminium (Al) and chromium (Cr). As described above, it is particularly preferable that a ferrite-based stainless substrate containing aluminium (Al) is used as the metal substrate 11. Further, it is preferable that the content of aluminium (Al) in the metal substrate 11 is greater than or equal to 0.5 weight % and less than or equal to 6.0 weight %. The thickness of the metal substrate 11 may be about 0.2 mm to 0.6 mm, for example.

Next, in a step illustrated in Fig. 3, the metal substrate 11 is baked (heated and oxidized, in other words, thermal oxidation) at temperature (this temperature may be referred to as pretreatment temperature) greater than or equal to 700 °C and less than 850 °C under air or atmosphere including oxygen to form the alumina layer 12 by diffusing aluminium (Al) included in the metal substrate 11 to the entire surface of the metal substrate 11. Here, the alumina layer 12 may be at least formed on the upper surface (element forming surface) of the metal substrate 11. This is because the adhesion between the alumina layer 12 formed on the upper surface of the metal substrate 11 and the insulating layer 13 that is formed right above the alumina layer 12 can be improved.

Here, the point that it is preferable that the pretreatment temperature is greater than or equal to 700 °C and less than 850 °C was experimentally found by the present inventors. According to the studies by the present inventors, when the pretreatment temperature is less than 700 °C, the adhesion between the insulating layer 13 is lowered because the alumina layer 12 is not sufficiently formed on the upper surface of the metal substrate 11. Further, if the pretreatment temperature is greater than or equal to 850 °C, the heat deformation amount of the metal substrate 11 becomes large and it becomes improper for the substrate of the compound thin-film photovoltaic cell, for which flatness is required. Further, there are other problems such as that a specific facility for heating is necessary and energy consumption for the heat treatment is large.

Specifically, when the alumina layer 12 is formed by the pretreatment temperature greater than or equal to 850 °C, "waviness", which is a difference of elevation of concavo-convex when the metal substrate 11 is placed on plane, largely exceeds an allowable value (less than or equal to 1 mm) of the substrate for the compound thin-film photovoltaic cell. Thus, it is difficult to use the metal substrate 11, in which the alumina layer 12 is formed by the pretreatment temperature greater than or equal to 850 °C, as the substrate for the compound thin-film photovoltaic cell.

On the other hand, when the pretreatment temperature is greater than or equal to 700 °C and less than 850 °C, the alumina layer 12 with the thickness sufficient to improve the adhesion with the insulating layer 13 that is directly formed thereon can be formed and the "waviness" of the metal substrate 11 can be suppressed to a value less than or equal to the allowable value (less than or equal to 1 mm) of the substrate for the compound thin-film photovoltaic cell. Here, as temperature greater than or equal to 700 °C and less than 850 °C is lower than general pretreatment temperature (greater than or equal to 850 °C and less than about 1100 °C) for forming an alumina layer, it is possible to reduce baking energy as well.

Here, in the step illustrated in Fig. 3, the metal substrate 11 may be configured as a continuous substrate including a plurality of regions, each of which becomes the substrate of the photovoltaic cell when being individualized, and the alumina layer may be continuously formed at least on the element forming surface of the plurality of regions. In other words, the continuous substrate may be continuously baked by a roll-to-roll process to form the alumina layer 12, and the substrate may be cut to be individualized thereafter. In such a case, in each of the substrates after being individualized, the element forming surface and the back surface are covered by the alumina layer, but the material of the substrate is exposed at the end surfaces (cut surfaces). Here, the continuous substrate may be cut to be individualized after the alumina layer 12 is formed, or after other layers are formed thereon.

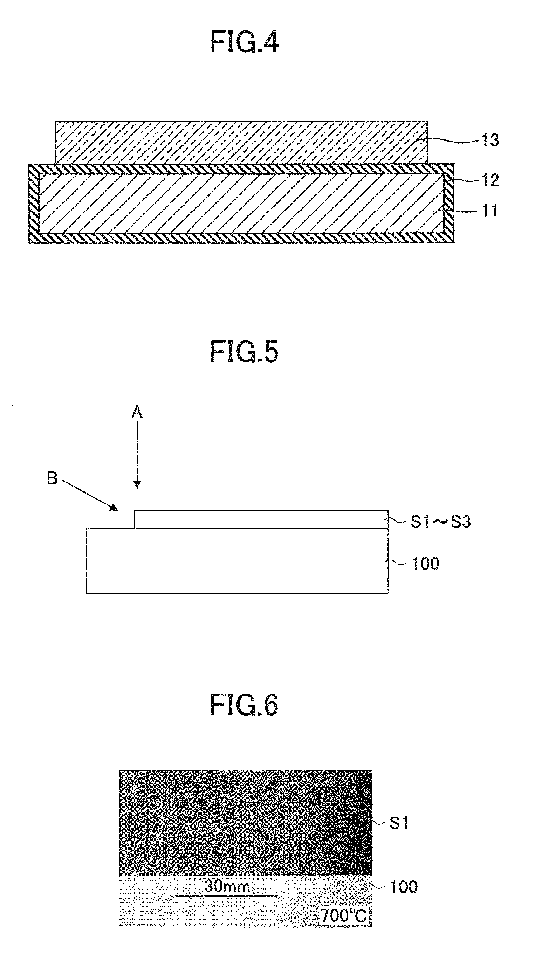

Next, in a step illustrated in Fig. 4, the insulating layer 13 is formed on the alumina layer 12 that is formed on the upper surface of the metal substrate 11. Specifically, for example, glass paste whose softening point is within 600 °C to 800 °C is coated on the alumina layer 12 that is formed on the upper surface of the metal substrate 11. The glass paste may be coated by a slit coater, for example. Instead of the slit coater, the glass paste may be coated by a spray coater, screen printing, a dip coater, a spin coater or the like.

Next, the coated glass paste is heated at about 100 °C to 200 °C in air to dry the glass paste and vaporize organic solvent in the glass paste. Further, by heating and baking the dried glass paste at temperature greater than or equal to the softening point, the insulating layer 13 is formed. It is preferable that the thickness of the insulating layer 13 after being baked is greater than or equal to 10 µm and less than or equal to 50 µm, and for example, may be about 30 µm. Here, as temperatures for the step of drying the glass paste and the step of heating and baking the glass paste are largely different, those steps may be performed in different apparatuses.

An example of the glass that can be used as the material of the insulating layer 13 is as described above. Further, as described above, the insulating layer 13 may be formed by a plurality of layers, and in such a case, the insulating layer 13 may include a layer that has the alkali barrier function.

Both the insulating layer 13 and the alumina layer 12 are layers made of oxide (oxide layers). As oxides have compatibility with each other, the adhesion between the insulating layer 13 and the alumina layer 12 is improved compared with a case when the insulating layer 13 is directly formed on the metal substrate 11 on which the alumina layer 12 is not formed (a case when the insulating layer 13 is directly formed on the metal substrate 11, which is not oxide).

Here, in a conventional metal substrate 11 in which the alumina layer 12 is not formed, the element forming surface of the metal substrate 11 is covered by extremely thin chromium oxide. In such a case, when the insulating layer 13 is directly formed on chromium oxide, it may be considered that an improvement effect of the adhesion due to oxides can be obtained. However, as chromium oxide is extremely thin (about a few nm to 10 nm, for example), the improvement effect of the adhesion cannot be obtained at all.

On the other hand, in this embodiment, as the thickness of the alumina layer 12 that covers the element forming surface of the metal substrate 11 is greater than or equal to 30 nm (in some cases, about 1 µm), which is far thicker than the thickness of chromium oxide (about a few nm to 10 nm, for example), the adhesion with the insulating layer 13 can be improved due to the compatibility of oxides. As such, the improvement effect of the adhesion between oxides occurs more as the thickness becomes thicker.

Further, as the alumina layer 12 is integrally formed by diffusing aluminium (Al) included in the metal substrate 11, not formed by a method such as depositing alumina on the upper surface of the metal substrate 11. Thus, an anchor effect is generated between the metal substrate 11 and the alumina layer 12 and the adhesion between the metal substrate 11 and the alumina layer 12 is improved compared with the case when a film is formed by depositing alumina on the upper surface of the metal substrate 11 or the like.

This means that the adhesion between the metal substrate 11 and the insulating layer 13 is improved compared with a conventional case by the intervention of the alumina layer 12. Thus, the delamination between the metal substrate 11 and the insulating layer 13 during manufacturing steps of the compound thin-film photovoltaic cell or in operation of the compound thin-film photovoltaic cell (in particularly, when being used under an environment where the temperature varies drastically), which may happen conventionally, can be suppressed.

Here, although an example is described in which the insulating layer 13 is an oxide layer, good adhesion with the alumina layer 12 can be obtained even when the insulating layer 13 is a nitride layer composed of silicon nitride or the like, similar for the case when the insulating layer 13 is the oxide layer. The insulating layer 13 composed of silicon nitride may be formed on the alumina layer 12 by reactive sputtering between silicon and nitrogen, a plasma CVD method or the like, for example.

The compound thin-film photovoltaic cell 10 illustrated in Fig. 1 is completed by stacking the first electrode layer 14, the compound light absorption layer 15 and the second electrode layer 16 on the insulating layer 13 in this order, after the steps illustrated in Fig. 4.

Specifically, the first electrode layer 14 is deposited on the insulating layer 13 by a DC magnetron sputtering method or the like, for example. Alternatively, the first electrode layer 14 may be deposited on the insulating layer 13 by an electron beam evaporation method or the like. The material, the thickness or the like of the first electrode layer 14 is as described above. Here, before depositing the first electrode layer 14, an alkali barrier layer may be formed by a sputtering method or the like. The material, the thickness or the like of the alkali barrier layer is as described above.

Next, copper indium gallium 2 sulfide-selenide (Cu(InGa)(SSe)₂) is deposited on the first electrode layer 14 as the compound light absorption layer 15. Copper indium gallium 2 sulfide-selenide (Cu(InGa)(SSe)₂) may be deposited by forming a precursor film including copper (Cu), gallium (Ga), indium (In) and the like by a DC magnetron sputtering method, an evaporation method or the like, for example, and thereafter, introducing selenide by hydrogen selenide (H₂Se) and sulfide by hydrogen sulfide (H₂S) (introduction process of selenide/ sulfide) at temperature about 400 to 600 °C, for example.

Here, instead of copper indium gallium 2 sulfide-selenide (Cu(InGa) (SSe)₂), the above described copper indium 2 selenide (CuInSe₂), copper indium 2 sulfide (CuInS₂) or the like may be deposited as the compound light absorption layer 15.

Further, the compound light absorption layer 15 may be deposited by vapor depositing copper (Cu), gallium (Ga), indium (In) and selenium (Se). Further, the compound light absorption layer 15 may be deposited by vapor depositing copper (Cu), gallium (Ga), indium (In) and sulfur (S). Further, the compound light absorption layer 15 may be deposited by vapor depositing copper (Cu), gallium (Ga), indium (In), selenium (Se) and sulfur (S). Further, the compound light absorption layer 15 may be deposited by a sputtering method, a hybrid sputtering method, a mechanochemical process method, a screen printing method, a close-spaced sublimation method, a MOCVD method, a spraying method or the like.

As the entire surface of the metal substrate 11 is covered by the alumina layer 12, corrosion of the entire surface of the metal substrate 11 due to hydrogen selenide (H₂Se), hydrogen sulfide (H₂S) or the like can be suppressed.

Here, after depositing the compound light absorption layer 15, in accordance with the necessity, a buffer layer may be deposited on the compound light absorption layer 15. The buffer layer may be deposited on the compound light absorption layer 15 by a Chemical Bath Deposition method (CBD method), a Metal Organic Chemical Vapor Deposition method (MOCVD method), an Atomic Layer Deposition method (ALD method) or the like, for example. The material, the thickness or the like of the buffer layer is as described above.

Next, the second electrode layer 16 is deposited on the compound light absorption layer 15 by a MOCVD method or the like, for example. Alternatively, the second electrode layer 16 may be formed on the compound light absorption layer 15 using a sputtering method, an evaporation method, an Atomic Layer Deposition method (ALD method) or the like. The material, the thickness or the like of the second electrode layer 16 is as described above. With the above described steps, the CIS-based compound thin-film photovoltaic cell 10 illustrated in Fig. 1 is completed.

Here, separating grooves may be formed in the first electrode layer 14, the compound light absorption layer 15 and the second electrode layer 16 and may form an integrated structure in which cells, which are separated and formed into strip shapes by the separating grooves separating grooves, are connected in series.

As such, in this embodiment, the alumina layer 12 is formed at least on the element forming surface of the metal substrate 11 and the insulating layer 13 is formed right about the alumina layer 12. With this, an anchor effect is generated between the metal substrate 11 and the alumina layer 12 and the adhesion therebetween can be improved. Further, the alumina layer 12 that is an oxide layer and the insulating layer 13 that is an oxide layer or a nitride layer are compatible with each other and the adhesion therebetween can be improved due to this reason. In other words, by the intervention of the alumina layer 12, the adhesion between the metal substrate 11 and the insulating layer 13 can be improved and the delamination between the metal substrate 11 and the insulating layer 13 can be suppressed. Thus, the compound thin-film photovoltaic cell 10 with good characteristics can be manufactured.

Further, as the pretreatment temperature when forming the alumina layer 12 is greater than or equal to 700 °C and less than 850 °C, which is lower than general pretreatment temperature (about greater than or equal to 850 °C and less than 1100 °C), baking energy can be reduced.

Further, the alumina layer 12 and the insulating layer 13 exist between the element forming surface of the metal substrate 11 and the lower surface of the first electrode layer 14. This means that as the metal substrate 11 and the first electrode layer 14 are separated by an insulating body of the two-layered structure including the stacked alumina layer 12 and the insulating layer 13, withstand voltage between the metal substrate 11 and the first electrode layer 14 can be improved.

### (Example 1)

In Example 1, a surface condition of the alumina layer 12 and deformation (warp or waviness) of the metal substrate 11 were confirmed. First, ferrite-based stainless substrates each containing aluminium (Al) (JFE18-3USR: a ferrite-based stainless substrate containing 3.4% of aluminium) were prepared as the metal substrate 11. The thickness of the prepared metal substrate 11 was 0.3 mm.

Then, a plurality of samples were manufactured by performing pretreatment on each of the metal substrates 11 to form the alumina layer 12 at the entire surface of each of the metal substrates 11. Specifically, three kinds of samples were manufactured including sample 1 for which the pretreatment temperature was 700 °C, sample 2 for which the pretreatment temperature was 750 °C and sample 3 for which the pretreatment temperature was 800 °C. In each of samples 1 to 3, the thickness of the alumina layer 12 was about 30 nm to 100 nm. Here, in Example 1, the insulating layer 13 or the like was not stacked on the alumina layer 12.

Next, as illustrated in Fig. 5, samples 1 to 3 (indicated as S1 to S3, respectively, in Fig. 5) in each of which the alumina layer 12 was formed at the entire surface of the metal substrate 11, were placed on an orientation plate 100 (a flat plate) in order, photographed from a direction of an arrow A (from upper side), and a surface condition of each of the samples was confirmed (Fig. 6 to Fig. 8).

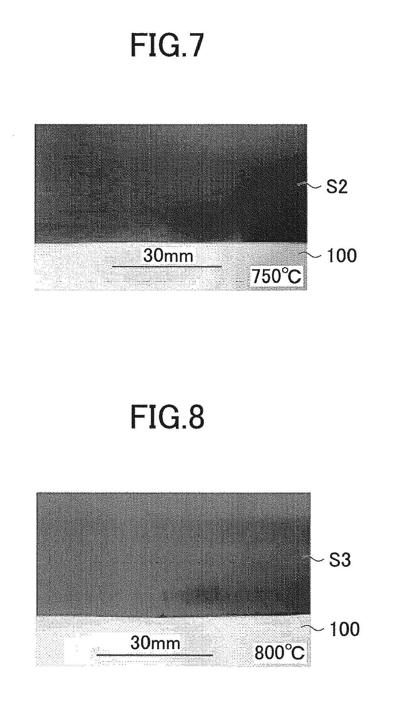

Fig. 6 illustrates a picture indicting the surface condition of sample 1, Fig. 7 illustrates a picture indicting the surface condition of sample 2 and Fig. 8 illustrates a picture indicting the surface condition of sample 3. In Fig. 6 to Fig. 8, the lower side of the respective drawing is the orientation plate 100 and the upper side of the respective drawing is each of samples 1 to 3 (illustrated as S1 to S3 in Fig. 6 to Fig. 8, respectively) in which the alumina layer 12 is formed at the entire surface of the metal substrate 11. As illustrated in Fig. 6 to Fig. 8, a uniform alumina layer 12 was formed in each of samples. Here, the length of the straight line illustrated in the orientation plate 100 corresponds to 30 mm.

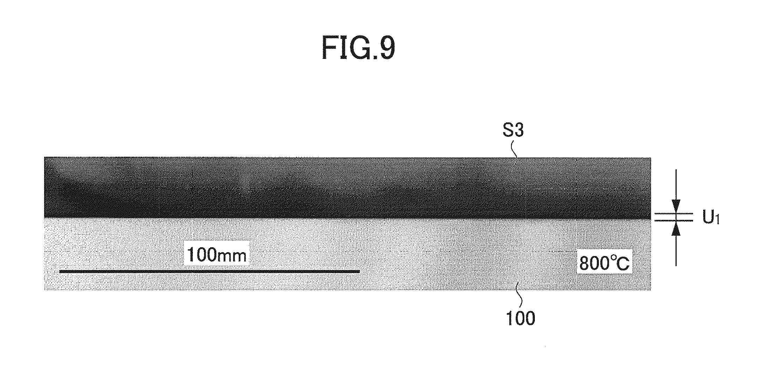

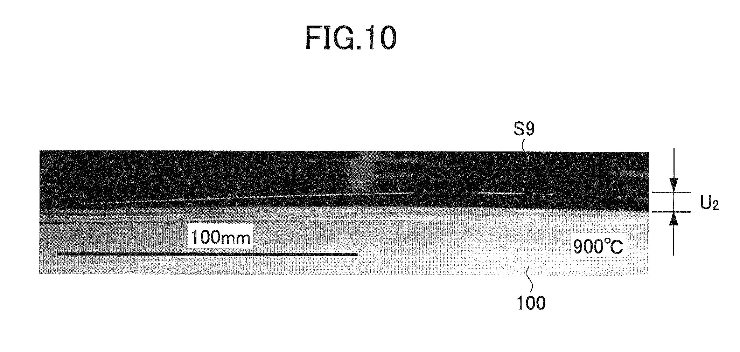

Next, as a comparative example, sample 9 was manufactured in which the alumina layer 12 is formed at the entire surface of the metal substrate 11 by performing pretreatment at pretreatment temperature of 900 °C on the prepared metal substrate 11. Then, samples 3 and 9 are placed on the orientation plate 100 (a flat plate) in order, photographed from a direction of an arrow B (from inclined upper side) in Fig. 5, and deformation (warp, waviness) of the metal substrate 11 of each of the samples was confirmed (Fig. 9 and Fig. 10).

Fig. 9 illustrates a picture of the metal substrate 11 of sample 3, and Fig. 10 illustrates a picture of the metal substrate 11 of sample 9. In Fig. 9 and Fig. 10, the lower side of the respective drawing is the orientation plate 100 and the upper side of the respective drawing is each of samples 3 and 9 (illustrated as S3 in Fig. 9 and S9 in Fig. 10) in which the alumina layer 12 is formed at the entire surface of the metal substrate 11. Here, the length of the straight line illustrated in the orientation plate 100 corresponds to 100 mm.

As illustrated in Fig. 9, it was confirmed that a warp or waviness was not generated at a surface of the metal substrate 11 that contacts the orientation plate 100 in sample 3 in which the pretreatment temperature was 800 °C. Further, the heat deformation amount U₁ (waviness) of sample 3 after the pretreatment was measured and it was confirmed that the heat deformation amount U₁ (waviness) was less than or equal to the above described allowable value of the waviness (less than or equal to 1 mm).

On the other hand, as illustrated in Fig. 10, for sample 9 in which the pretreatment temperature was 900 °C, a warp or waviness was generated at a surface of the metal substrate 11 that contacts the orientation plate 100. Further, the heat deformation amount U₂ (waviness) of sample 9 after the pretreatment was measured and it was confirmed that waviness of about 5 mm, which exceeds the above described allowable value of the waviness (1 mm), was generated and was inappropriate for the substrate for the photovoltaic cell.

### (Example 2)

In Example 2, whether delamination occurred at an interface between the alumina layer 12 and the insulating layer 13 was confirmed. First, the metal substrate 11 similar to that of Example 1 was prepared.

Then, pretreatment was performed on the prepared metal substrate 11, and a plurality of samples in each of which the alumina layer 12 was formed at the entire surface of the metal substrate 11 were prepared. Specifically, two kinds of samples were prepared including sample 4 in which the pretreatment temperature was 750 °C and sample 5 in which the pretreatment temperature was 800 °C. In each of samples 4 and 5, the thickness of the alumina layer 12 was about 30 nm to 100 nm.

Next, the insulating layer 13 was stacked on the alumina layer 12 of each of samples 4 and 5 by a glass. Thereafter, the interface of the alumina layer 12 and the insulating layer 13 was observed for each of samples 4 and 5 and no delamination was confirmed for both the cases.

As such, according to Examples 1 and 2, it was confirmed that the heat deformation of the metal substrate 11 was suppressed by forming the alumina layer 12 at least on the element forming surface of the metal substrate 11 by pretreatment temperature of greater than or equal to 700 °C and less than 850 °C, which is lower than the conventional method. Further, it was confirmed that when the insulating layer 13 was stacked on the formed alumina layer 12, the alumina layer 12 and the insulating layer 13 sufficiently adhere and the delamination of the interface of the alumina layer 12 and the insulating layer 13 was not generated. When considering that an anchor effect is generated between the metal substrate 11 and the alumina layer 12 and the adhesion therebetween is improved as well, it can be said that the adhesion between the metal substrate 11 and the insulating layer 13 was improved by the intervention of the alumina layer 12.

Although preferred embodiments and examples have been specifically illustrated and described, it is to be understood numerous variations and modifications may be made without departing from the spirit and scope of the present invention.

The present application is based on and claims the benefit of priority of Japanese Priority Application No. 2012-286186 filed on December 27, 2012, the entire contents of which are hereby incorporated by reference.

### [Numerals]

- 10: compound thin-film photovoltaic cell
- 11: metal substrate
- 12: alumina layer
- 13: insulating layer
- 14: first electrode layer
- 15: compound light absorption layer
- 16: second electrode layer

## Claims

1. A method of manufacturing a compound thin-film photovoltaic cell, comprising:
preparing a metal substrate, whose main constituent is iron, containing aluminium (Al) and chromium (Cr), and forming an alumina layer at least on an element forming surface of the metal substrate by thermal oxidation;
forming an insulating layer on the alumina layer;
depositing a first electrode layer on the insulating layer;
depositing a compound light absorption layer on the first electrode layer; and
depositing a second electrode layer on the compound light absorption layer.

2. The method of manufacturing the compound thin-film photovoltaic cell according to claim 1,
wherein the insulating layer is an oxide layer .

3. The method of manufacturing the compound thin-film photovoltaic cell according to claim 1,
wherein the insulating layer is a glass layer.

4. The method of manufacturing the compound thin-film photovoltaic cell according to claim 3,
wherein the glass layer is formed by heating and baking.

5. The method of manufacturing the compound thin-film photovoltaic cell according to claim 3,
wherein the thickness of the glass layer is greater than or equal to 10 µm and less than or equal to 50 µm.

6. The method of manufacturing the compound thin-film photovoltaic cell according to claim 1,
wherein the content of aluminium (Al) in the metal substrate is greater than or equal to 0.5 weight % and less than or equal to 6.0 weight %.

7. The method of manufacturing the compound thin-film photovoltaic cell according to claim 1,
wherein the metal substrate is a stainless substrate including aluminium (Al).

8. The method of manufacturing the compound thin-film photovoltaic cell according to claim 7,
wherein the metal substrate is a ferrite-based stainless substrate including aluminium (Al).

9. The method of manufacturing the compound thin-film photovoltaic cell according to claim 1,
wherein in the forming the alumina layer, the alumina layer is formed at temperature greater than or equal to 700 °C and less than 850 °C.

10. The method of manufacturing the compound thin-film photovoltaic cell according to claim 1,
wherein the metal substrate is a continuous substrate including a plurality of regions that each becomes a substrate of the photovoltaic cell when being individualized, and
wherein in the forming the alumina layer, the alumina layer is continuously formed at least on the element forming surface of the plurality of the regions.

11. The method of manufacturing the compound thin-film photovoltaic cell according to claim 1,
wherein in the forming the alumina layer, the alumina layer is formed at least on the element forming surface and a back surface of the metal substrate.

12. The method of manufacturing the compound thin-film photovoltaic cell according to claim 1,
wherein the compound light absorption layer is a CIS-based compound thin-film.

13. A compound thin-film photovoltaic cell, comprising:
a metal substrate, whose main constituent is iron, containing aluminium (Al) and chromium (Cr);
an alumina layer formed at least on an element forming surface of the metal substrate by thermal oxidation;
an insulating layer formed on the alumina layer;
a first electrode layer deposited on the insulating layer;
a compound light absorption layer deposited on the first electrode layer; and
a second electrode layer deposited on the compound light absorption layer.

14. The compound thin-film photovoltaic cell according to claim 13,
wherein the insulating layer is an oxide layer.

15. The compound thin-film photovoltaic cell according to claim 13,
wherein the insulating layer is a glass layer.

16. The compound thin-film photovoltaic cell according to claim 15,
wherein the thickness of the glass layer is greater than or equal to 10 µm and less than or equal to 50 µm.

17. The compound thin-film photovoltaic cell according to claim 13,
wherein the content of aluminium (Al) in the metal substrate is greater than or equal to 0.5 weight % and less than or equal to 6.0 weight %.

18. The compound thin-film photovoltaic cell according to claim 13,
wherein the metal substrate is a stainless substrate containing aluminium (Al).

19. The compound thin-film photovoltaic cell according to claim 18,
wherein the metal substrate is a ferrite-based stainless substrate containing aluminium (Al).

20. The compound thin-film photovoltaic cell according to claim 13,
wherein the alumina layer is formed at least on the element forming surface and a back surface of the metal substrate.

21. The compound thin-film photovoltaic cell according to claim 13,
wherein the compound light absorption layer is a CIS-based compound thin-film.
